# EUROPEAN PATENT APPLICATION

(11) **EP 2 296 136 A1**
(43) Date of publication of application: **16.03.2011**
(21) Application number: 09169660.9
(22) Date of filing: 07.09.2009
(51) Int. Cl.: G09G 3/34

(54) **Backlight control circuit**

(71) Applicant: NXP B.V., 5656 AG Eindhoven (NL)
(72) Inventor: Uguen, Emeric, Redhill, Surrey RH1 1DL (GB); VIX, Regis, Redhill, Surrey RH1 1DL (GB)
(74) Representative: Williamson, Paul Lewis

(57) **Abstract**

A display device backlight comprises at least one LED (10) and a control circuit for controlling the brightness of the LED, wherein the control circuit comprises a drive transistor (14) for driving a current through the LED and a pulse width modulation circuit for controlling the timing of operation of the drive transistor. A compensation circuit (50) provides a first boost current to the gate of the drive transistor during a rising edge of the current profile and provides a second boost current to the gate of the drive transistor during a falling edge of the current profile. This arrangement improves the switching response of the drive transistor by providing boost currents to/from the gate of the drive transistor during the rising and falling edges of the current through the drive transistor (in response to steps in the PWM control signal).

## Description

This invention relates to display devices, for example display devices using a backlight as an illumination light source, with the display device modulating the light from the backlight.

A liquid crystal display is the most common example of this type of modulating display device, and typically comprises an active plate and a passive plate between which liquid crystal material is sandwiched. The active plate comprises an array of transistor switching devices, typically with one transistor associated with each pixel of the display. Each pixel is also associated with a pixel electrode on the active plate to which a signal is applied for controlling the brightness of the individual pixel.

The control of the backlight brightness is desirable for a number of reasons. Primarily, it enables energy savings to be made, if the backlight brightness can be reduced. For example, the level of ambient light has a strong influence on the performance of a backlit display device, and it has been recognised that the performance of displays can be improved by adjusting the intensity of the backlight of the display in response to information from light sensors which are able to sense the characteristics of the ambient illumination. This provides a means of reducing the power consumption of the display when the ambient light levels are low, and to provide a good quality output when the ambient light levels are high.

Most current LCD displays use CFL backlights, but LED backlights are being investigated for future LCD backlight solutions, because they allow improved compactness and greater energy saving capability.

There are two ways of adjusting the backlight brightness of an LED backlight system. Either the DC current through the LED is directly adapted (analogue dimming), or a PWM modulation of the LED DC current (digital or PWM dimming) allows the same result of controlling the average power transmitted to LEDs.

PWM modulation results in a simple control command from the system point of view, and as it guarantees the colour temperature is not altered (the colour of light emitted by a LED changes slightly with its DC current), this is the preferred control mechanism for backlight brightness control.

To be able to improve the general image quality and the contrast in particular, it is desirable to be able to produce more light for a shorter period (for example 200mA during 10% of the PWM period rather than 50mA during 40% of the period).

The fact the LED manufacturers are now able to produce better high brightness LEDs allows the contrast to be improved as explained above, by adopting shorter PWM ratios. However, in case of low to very low PWM ratios, any difference of rising edge delay versus falling edge delay, or any slope alteration, will cause a PWM command distortion. Thus, the quality of the circuit response to the digital PWM waveform becomes a significant factor in the quality of the control scheme.

According to the invention, there is provided a display device backlight comprising:
at least one LED; and
a control circuit for controlling the brightness of the LED, wherein the control circuit comprises a drive transistor for driving a current through the LED and a pulse width modulation circuit for controlling the timing of operation of the drive transistor,
wherein the control circuit further comprises a compensation circuit for providing a first boost current to the gate of the drive transistor during a rising edge of the current profile and for providing a second boost current to the gate of the drive transistor during a falling edge of the current profile.

This arrangement improves the switching response of the drive transistor by providing boost currents to/from the gate of the drive transistor during the rising and falling edges of the current through the drive transistor (in response to steps in the PWM control signal).

The first and second boost currents can be controlled so that the rising and falling edges of the current profile through the drive transistor are controlled to have substantially equal slope and/or delays.

It is noted that the term "boost current" is used to express a current used to boost the switching response. It may be an injected current or a drained current, depending on the drive transistor type and the switching being carried out. For example, for an n-type drive transistor, a high gate voltage is used to turn on the transistor, so that the parasitic gate capacitance first has to be charged, hence the first boost current is an injected current. When the gate voltage is brought low, the second boost current is a draining current, as the parasitic gate capacitance has to be discharged.

The drive transistor can be a series n-type transistor above the current source. The mismatch between the rising and falling PWM edge delays is mainly due to the time needed to charge the PWM switch gate until the threshold voltage to start conduction for the rising edge, versus almost immediate switch off during the falling PWM edge. Thus, the first and second boost currents may not be equal, and they may not be applied for equal lengths of time.

The compensation circuit is preferably adapted to provide the first boost current only when the current through the drive transistor is below a fraction of its final value, and the compensation circuit is preferably adapted to provide the second boost current only when the current through the drive transistor is above a fraction of its final value. Thus, the boosting is only for the initial time of the PWM switching event. With the switching-on edge of the drive transistor, providing a boost current only for a fraction of the rising edge (i.e. until a fraction of the final current is reached) prevents overshoot in the final current value. The fraction can for example be between 10% and 90%. The boosting can be for less than 60% of the rising edge, or even less than 50% (i.e. in the range 10% to 50%).

The compensation circuit can comprise a current comparison circuit for determining when an increasing current through the drive transistor has reached a first threshold, and for determining when a decreasing current through the drive transistor has reached a second threshold. The thresholds can be the same (e.g. 50%) or they may be different. For example, the first threshold may be 30% (so that the boosting is for 30% of the rising edge) and the second threshold can be 70% (so that the boosting is again for 30% of the falling edge). These different thresholds can be implemented by a device with hysteresis, for example a Schmidt trigger.

The current comparison circuit can comprise a current mirror which mirrors the current through the drive transistor and a reference current source which determines the first and second thresholds.

The compensation circuit can comprise a push transistor of first conductivity type between a high power line and the gate of the drive transistor and a pull transistor of second, opposite, conductivity type between the gate of the drive transistor and a low power line. The push transistor can be p-type and the pull transistor n-type.

The invention also provides a display device comprising a display device backlight of the invention, and a display panel comprising pixels for modulating the backlight output.

The invention also provides a method of controlling a display device backlight which comprises at least one LED and a control circuit for controlling the brightness of the LED, comprising:
driving a current through the LED using a pulse width modulation scheme which controls the timing of operation of a drive transistor by applying a control signal to the gate of the drive transistor,
wherein the method comprises providing a first boost current to the gate of the drive transistor during a rising edge of the current profile and providing a second boost current to the gate of the drive transistor during a falling edge of the current profile.

An example of the invention will now be described in detail with reference to the accompanying drawings, in which:
Figure 1 shows schematically how PWM control of the current through an LED can be implemented;
Figure 2 shows an example of amplifier for generating the high gate control signal for the PWM switch;
Figure 3 shows the operating region of the PWM switch to explain how differences arise between rising and falling edges of the control signal;
Figure 4 shows an example of backlight and control circuit of the invention;
Figure 5 shows the improvement in current waveform achieved by the backlight and control circuit of Figure 4; and
Figure 6 shows a display device of the invention.

In the preferred examples, the invention provides a compensation circuit for providing a boost current to the gate of the drive transistor (for example an n-type transistor) during a rising edge of the current profile through the LED, and for draining a current from the gate of the drive transistor during a falling edge of the current profile. This enables the rising & falling current edge slopes in response to the PWM signal to be matched and/or enables the rising & falling edge delays to be matched. This in turn enables short duty cycle PWM control to be implemented. The PWM control signal can have a ratio of below 1% up to the full 100% duty. However, low PWM duty cycles may be desired, for example a duty cycle of less than 40%, or less than 20% and even lower than 10%. For example, for the control of a colour triplet of LEDs, the duty cycle ration may be maintained below 33%, with a 120 degree phase shift between the signals for the three LEDs, so that the current demands on the power supply are smoothed.

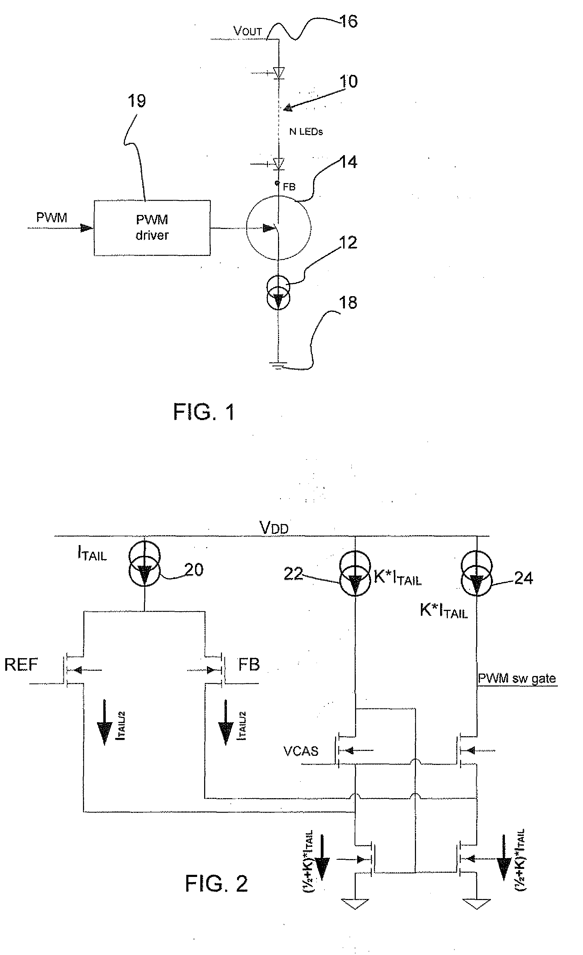

Figure 1 shows schematically how PWM control of the current through a LED can be implemented. In practice, a string 10 of LEDs is controlled. This LED string 10 may define a complete backlight, or the backlight may be segmented into multiple strings, so that different portions of the backlight can be controlled independently.

Each LED string 10 is in a series arrangement with a current source 12 and a PWM switch 14 between a power line 16 at the LED supply voltage V_{OUT} and ground 18. The system has to guarantee V_{OUT} is high enough to allow the LEDs to produce light.

The PWM switch is controlled by a PWM driver 19, which controls the duty cycle with which the switch is turned on and off. The PWM control signal is shown as "PWM".

One of the objectives of such an application is to produce light with the highest power efficiency achievable. For this goal the feedback voltage FB between the PWM switch and the LED string should be as low as possible, in order to minimize dissipation of energy inside the circuit, and so that the greatest fraction of the supply voltage is dropped across the LEDs.

This can be achieved by having the current source 12 and PWM switch 14 as large as possible (so that they have low resistance). However, sizing the PWM switch to have relatively small serial resistance comes with the drawback of a large parasitic gate capacitance.

The aim of the PWM driver 19 is to charge and discharge the parasitic gate capacitance. As the parasitic capacitance is not different between rising and falling edges, the best solution to balance both slopes is to balance both charge and discharge currents.

In the architecture of Figure 1, the PWM switch 14 assumes two simultaneous functions: PWM switch and cascode transistor for current copying. The PWM driver thus also plays two different roles: PWM driver and active current copy amplifier.

A folded cascode amplifier can be used as part of the control circuit as it also ensures a good control of the charge and discharge current for the PWM switch gate capacitance. A (known) example of the circuit is shown in Figure 2. The cascode amplifier functions both as an active current mirror circuit for current regulation, and driver for the PWM switch.

A target level for the feedback voltage FB is set, which is low enough that there is a small voltage drop across the PWM switch and current source, but high enough for the PWM switch to function correctly. This reference voltage REF (e.g. 300mV) is supplied as the non-inverting input in Figure 2. The actual voltage FB is supplied as the inverting input in Figure 2. The circuit of Figure 2 then regulates the PWM signal applied to the gate of the PWM switch ("PWM sw gate") to maintain the desired voltage FB.

The circuit of Figure 2 has a reference current source 20 with current value I_{TAIL}, and two mirrored current sources 22,24 with current value KI_{TAIL}. The voltage VCAS is applied to the cascode transistors with a level high enough for the bottom current mirror to operate in the saturated region and low enough to maintain large output dynamic range.

The PWM switch is controlled by the circuit of Figure 2 to provide the on gate signal for the PWM switch. Thus, the PWM signal acts as an enable signal for the amplifier. In addition, the PWM signal pulls the PWM gate control signal ("PWM sw gate") low when the PWM signal is low (the circuits elements for pulling "PWM sw gate" low are not shown in Figure 2).

The design of the cascode amplifier does not form part of the invention, and for reason further details of the possible design and operation are not presented. The amplifier circuit is conventional and it will be routine to those skilled in the art. Indeed different designs can be used. Essentially, the amplifier provides a high gate control signal which is regulated such that the drive transistor maintains a desired voltage across the LED string (either by using the end of the resistor string as a feedback input or using another related point in the circuit as feedback point, such as the node between the current source and the PWM switch). The amplifier circuit drives the PWM switch high or low so that the PWM switch is actively driven on or off.

The charging and discharging currents are not strictly equal in the folded cascode architecture (K*ITAIL versus [½+K]*ITAIL) and increasing the K value will reduce the mismatch between the two currents. Thus, a high K factor improves the symmetry of operation, but results in larger currents and reduced efficiency.

However, making the K factor too big will have an impact on the application efficiency, so that the sizing of this K factor is a trade-off between slope symmetry and efficiency.

The efficiency concern is a good reason to limit the K value, but not the central one. In most applications, the LEDs are not connected directly to the driver output, but through centimetre-long wires (almost 100cm in the case of large flat screen TVs); these wires have a non-negligible intrinsic inductance value. Such a parasitic inductance in conjunction with steep fronts on the PWM response cause overshoots, ringing and ripple at the FB node.

This noise on long wires could potentially generate electromagnetic interference (EMI) through the whole system, so these overshoots must also be prevented or at least reduced as much as possible. One way to achieve this is to limit the PWM slopes.

Even with a K factor relatively small (i.e. K=1.5) to reduce EMI and avoid having a significant impact on the efficiency, the mismatch between the delays in the rising and falling edge due to different PWM slopes is around 33%. This mismatch is significant only in the case of small to very small PWM duty cycles, otherwise the duration of the PWM is very large compared to rise or fall time, and those rise and fall times are negligible versus the time the PWM switch is on. In the case of small PWM ratios, another asymmetry is more problematic than the slope mismatch, namely the delay between the PWM command and the response of the system. The asymmetry of the two fronts is caused by the MOS nature of the serial PWM switch, because MOS behaviour is radically different depending on the region of operation of the device.

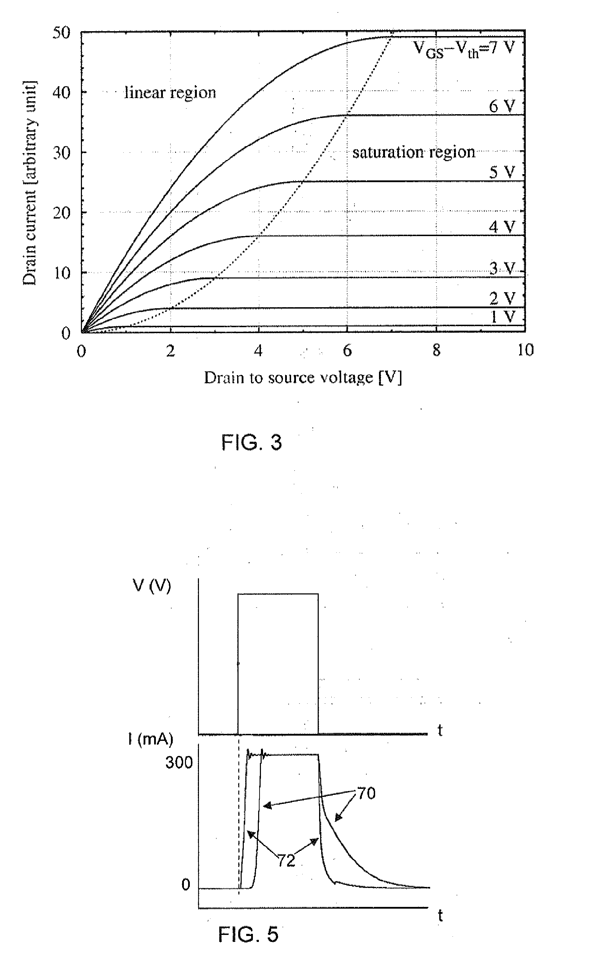

Figure 3 shows general transistor characteristics, which apply to the PWM switch, to demonstrate how differences arise between rising and falling edges of the control signal. The graph plots the drain current against the source-drain voltage, for different gate voltages, and shows the linear region and the saturation region.

During a rising PWM edge, the switch starts from the linear region to reach the saturated region, and the MOS conduction is very bad as long as the gate voltage is below threshold voltage. On the PWM falling edge, the switch is already in saturation and then the response time is far faster as there is no need to pre-charge (or pre-discharge in this case) the gate potential to a threshold voltage in order to have immediate response. The steepness of the falling edge decreases when the MOS gate voltage is brought sufficiently low that it tends to equal the MOS threshold voltage (see Figure 5).

One potential solution to solve the response time on the rising edge would be to pre-charge the MOS gate just below the threshold voltage. In this way, once current would be injected on this gate, the switch would enter into conduction with a delay reduced to a minimum value. This solution is not beneficial for the falling edge and is susceptible to process, temperature variations and ground pollution.

The invention provides response time compensation to avoid low PWM ratio distortion, by boosting the charge and discharge of the important parasitic gate capacitance by injecting/draining additional current for a short period of time, in order to reach the final gate voltage faster. This current boosting operation is used to improve the rising edge response time, but it also is used to make the rise and fall slopes in the current through the drive transistor of equal slope and hence duration.

This drastically improves the steepness of the edges and maintains the PWM width.

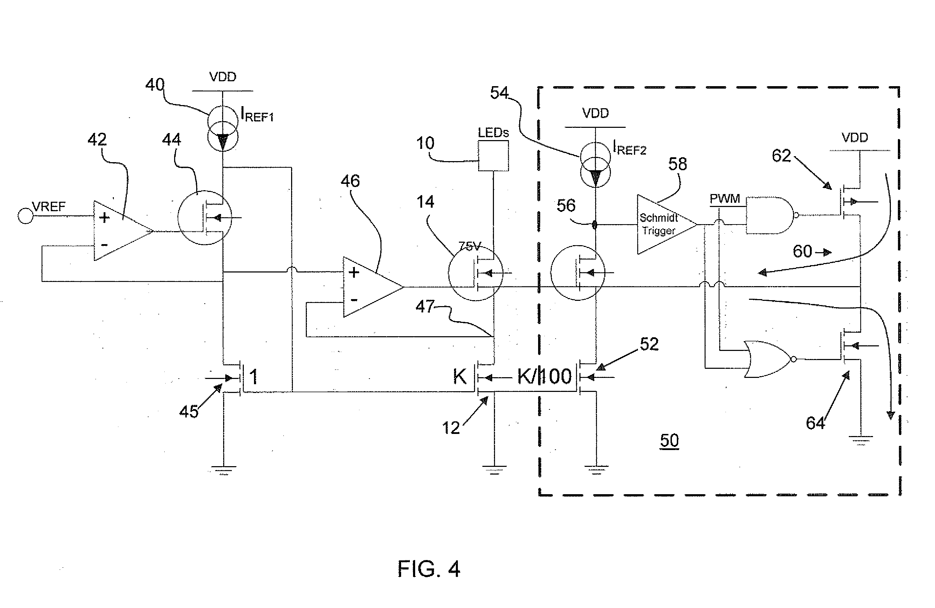

Figure 4 shows an example of backlight and control circuit of the invention.

The circuit comprises the series chain of LED string 10, PWM switch 14 and current source 12. The current source 12 is a current mirror which provides a scaled version (with factor K) of a reference current source 40 (current I_{REF1}) . The circuit provides a reference voltage VREF between the PWM switch 14 and the current source transistor 12.

The reference voltage VREF is provided to an input amplifier 42, which provides the reference voltage to the gate and drain of an input transistor 44 which drives the reference current through a first current mirror transistor 45. The size ratio between the first current mirror transistor 45 and the transistor 12 determines the current flow through the LED string.

The reference voltage VREF is provided to the non-inverting input of a second amplifier 46, and the non-inverting input is coupled to the node 47 between the PWM switch and the current source transistor 12. The amplifier 46 can be a folded cascode amplifier as shown in Figure 2, and it maintains the voltage at the node 47 at the desired level. The amplifier 46 can instead be used to hold the node between the PWM switch and the LED string at a desired voltage as in Figure 2.

The parts of the circuit so far described are conventional, and indeed many different implementations are possible. The invention simply requires a PWM switch in the form of a transistor which drives current through the LED string. The precise way in which the voltages at the terminals of the PWM switch and the LED string are controlled is not material to the invention, and the example given is purely for explanation purposes.

The invention provides a compensation circuit 50. This is used to sample the current through the LED string, and this is achieved with a further current mirror transistor 52. By way of example, this generates a small fraction (1/100) of the LED current.

A second reference current source 54 (current I_{REF2})provides a current to a node 56, so that the difference between the current mirrored by the transistor 52 and the reference current I_{REF2} is provided to a hysteresis device such as a Schmidt trigger 58.

The Schmidt trigger 58 controls a parallel push-pull driver 60 for the PWM switch gate. This driver 60 provides a current boost for a short period of time, and the amount of boosting current is limited by the component geometry. The driver is controlled by the digital PWM signal. The purpose of this driver is not to control the slopes but just to provide extra drive current at the critical step of the PWM fronts, particularly so that a boost current is provided at the right time for the right duration.

The push part of the boost driver 60 in the form of a p-type transistor 62 provides extra current at the PWM rising edge and the pull part of the driver in the form of an n-type transistor 64 provides its extra current at the falling edge of the PWM driver. The sensing of the LED current directly is used to enable a control scheme to be implemented which limits the duration of the boost current.

In particular, the boost current is provided only as long as the LED current is below a preset fraction of its final value during the rising edge, and above this same fraction during the falling PWM edge. Thus, the boosting takes place at the beginning of the PWM transition in both directions.

The current comparison information is digitalized by the Schmidt trigger, and a logic circuit derives the control voltages for the driver 60. In the example shown, the logic circuit comprises a NAND gate and a NOR gate, although other logic configurations are of course possible. The push and pull stages are operated only one at a time and only during a transition edge of the current waveform through the drive transistor (and therefore the LED string).

In respect of a rising edge, the PWM signal switches from 0 to 1. The current mirror current of transistor 52 is initially low, so that the reference current I_{REF2} flows to the Schmidt trigger, which provides a high output. The NAND gate generates a low output which turns on the transistor 60. This only remains on until the current through transistor 52 has increased such that the current to the Schmidt trigger has dropped below the switching point. The transistor 62 is then turned off. The current level to be reached is known, and the Schmidt trigger is selected to provide switching when the desired fraction of the final current has been reached.

In respect of a falling edge, the PWM signal switches from 1 to 0. The current mirror current of transistor 52 is initially high, so that little current flows to the Schmidt trigger, which provides a low output. The NOR gate generates a high output which turns on the transistor 64. This only remains on until the current through transistor 52 has decreased such that the current to the Schmidt trigger has increased above the switching point. The transistor 64 is then turned off. The current level to be reached is known, and the Schmidt trigger is selected to provide switching when the desired fraction of the final current has been reached. The hysteresis of the Schmidt trigger effectively enables the two switching currents to be selected. For example, for the rising edge, the current boost can up to 40% of the current level (although up to other fractions are possible, for example up to somewhere between 5% and 50%), and for the falling edge the current boost (which can be considered as a draining current) can be down to 60% of the current level (again down to other fractions are possible, for example down to somewhere between 50% and 95%). The symmetry in the example above (the 40% range during which current boosting is applied) is not however essential. Also, there may be a single current level at which switching takes place so that no hysteresis is needed. Also, a hysteresis logic circuit can be implemented with comparators and logic gates - so that a Schmidt trigger is only one example.

In general, the comparison circuit determines when an increasing current through the drive transistor has reached a first threshold, and determines when a decreasing current through the drive transistor has reached a second threshold. These thresholds may be the same or different.

The current comparison level has to be set relatively low as it has to be active when the PWM gate voltage is below the n-channel MOS threshold voltage. The boost current is only added during the first part of the slope avoiding creating more overshoot, ringing and rippling due to too high energy transfer at the end of the PWM rising edge.

Using a current mirror image of the LED current to perform the comparison ensures process and temperature independence, because the boost current is injected once the PWM has been enabled independently from the NMOS threshold voltage value.

Figure 5 shows the improvement in current waveform achieved by the backlight and control circuit of Figure 4. The top plot shows the PWM signal. The bottom plot shows the current waveform through the drive transistor when no compensation is applied (plot 70) and when the compensation scheme described above is applied (plot 72). The delay is reduced as shown, and the rise and fall slopes of the current profile are much more symmetrical. Excessive overshoot is also avoided, in that the overshoot has not increased by applying the compensation scheme.

This invention can be used in any LED backlight for liquid crystal displays (or other light modulating display technology). The application range is thus broad as it includes flat TV, computer monitors, laptop screens or various portable device displays.

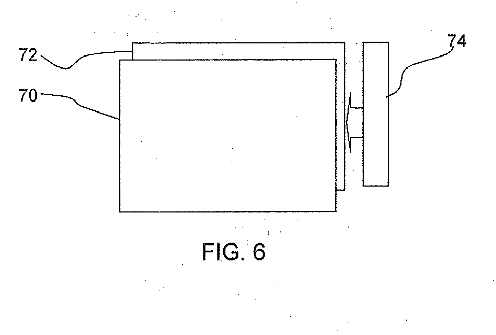

Figure 6 shows schematically a display device of the invention, comprising a display panel 70, and a backlight 72. The display panel 70 modulates the output of the backlight, and typically comprises an LC panel. A backlight controller 74 includes the control circuitry outlined above.

The invention enables smaller PWM ratios to be reached, reduces PWM distortions as the digital PWM command is accurately duplicated without change to the duty cycle ratio. The compensation is independent of process variations as the LED current is directly monitored, and monitored the same way whatever the process and temperature conditions. The compensation enables improved current switching without requiring large current mirror circuits in the drive amplifiers.

This invention makes possible a very accurate progressive dimming in the low brightness ranges.

The elimination of any delay between the PWM command and the rising edge shows that the NMOS switch is either pre-charged or boosted.

The invention may be applied to any display type having an illumination source, such as transflective displays.

Various modifications will be apparent to those skilled in the art.

## Claims

1. A display device backlight comprising:
at least one LED (10); and
a control circuit for controlling the brightness of the LED, wherein the control circuit comprises a drive transistor (14) for driving a current through the LED and a pulse width modulation circuit (19) for controlling the timing of operation of the drive transistor,
wherein the control circuit further comprises a compensation circuit (50) for providing a first boost current to the gate of the drive transistor during a rising edge of the current profile and for providing a second boost current to the gate of the drive transistor during a falling edge of the current profile.

2. A display device as claimed in claim 1, wherein the compensation circuit (50) is adapted to provide the first boost current only when the current through the drive transistor (14) is below a fraction of its final value, and the compensation circuit (50) is adapted to provide the second boost current only when the current through the drive transistor (14) is above a fraction of its final value.

3. A display device backlight as claimed in claim 1, wherein the compensation circuit (50) comprises a current comparison circuit (52,54,58) for determining when an increasing current through the drive transistor (14) has reached a first threshold, and for determining when a decreasing current through the drive transistor (14) has reached a second threshold.

4. A display device backlight as claimed in claim 3, wherein the current comparison circuit (52,54,58) comprises a Schmidt trigger (58).

5. A display device backlight as claimed in claim 3 or 4, wherein the current comparison circuit (52,54,58) comprises a current mirror (52) which mirrors the current through the drive transistor (14) and a reference current source (54) which determines the first and second thresholds.

6. A display device backlight as claimed in any preceding claim, wherein the compensation circuit (50) comprises a push transistor (62) of first conductivity type between a high power line (VDD) and the gate of the drive transistor and a pull transistor (64) of second, opposite, conductivity type between the gate of the drive transistor (14) and a low power line.

7. A display device backlight as claimed in claim 6, wherein the push transistor (62) is p-type and the pull transistor (64) is n-type.

8. A display device backlight as claimed in any preceding claim, wherein the rising and falling edges of the current profile through the drive transistor (14) have substantially equal slope.

9. A display device backlight as claimed in any preceding claim, wherein the rising and falling edges of the current profile through the drive transistor (14) have substantially equal delays.

10. A display device comprising a display device backlight (72) as claimed in any preceding claim, and a display panel (70) comprising pixels for modulating the backlight output.

11. A method of controlling a display device backlight which comprises at least one LED and a control circuit for controlling the brightness of the LED, comprising:
driving a current through the LED using a pulse width modulation scheme which controls the timing of operation of a drive transistor (14),
wherein the method comprises providing a first boost current to the gate of the drive transistor (14) during a rising edge of the current profile and providing a second boost current to the gate of the drive transistor (14) during a falling edge of the current profile.

12. A method as claimed in claim 11, comprising providing the first boost current only when the current through the drive transistor (14) is below a fraction of its final value, and providing the second boost current only when the current through the drive transistor is above a fraction of its final value.

13. A method as claimed in claim 11 or 12, wherein the rising and falling edges of the current profile through the drive transistor are controlled to have substantially equal slope.

14. A method as claimed in any preceding claim, wherein the rising and falling edges of the current profile through the drive transistor are controlled to have substantially equal delays.
